# EUROPEAN PATENT APPLICATION

(11) **EP 4 482 265 A2**
(43) Date of publication of application: **25.12.2024**
(21) Application number: 24179676.2
(22) Date of filing: 03.06.2024
(51) Int. Cl.: H05K 3/00, B28D 5/00, B65G 17/32, B26F 3/00, B26D 3/06, B26D 7/06, B26D 7/18, H05K 1/03

(54) **METHOD FOR SINGLING OUT CIRCUITS FROM A SUBSTRATE PROVIDED WITH A PASTE LAYER**

(30) Priority: 01.06.2023 BE 202305444
(71) Applicant: C-MAC Electromag bv, 9600 Ronse (BE)
(72) Inventor: AMEZ, Bart, 9600 Ronse (BE); DETEMMERMAN, Danny, 9600 Ronse (BE)
(74) Representative: Brantsandpatents bv

(57) **Abstract**

The present invention concerns a method for singling out electronic circuits out of a substrate board comprising a paste layer substantially covering a first side of the substrate board, each substrate board comprising a plurality of said circuits disposed in at least one row. The method according to the invention, overcomes the issues related to the division of a board comprising a brittle material and at least one ductile material deposited on the surface of said brittle material.

## Description

### FIELD OF THE INVENTION

The invention relates to an automated system for singling out circuits from substrates, which substrates are provided with a solderable conductor layer, specifically for singling out circuits from so-called Direct Copper Bonding substrates, DBC. In addition, methods are described for this purpose, as well as for an adjustment and method for removing loss edges from substrates. Finally, an overarching system is described and the final product of the methods.

### BACKGROUND

JP2013043348 discloses a method for subdividing a plate of brittle material along a fracture line formed by means of a laser or a tool. JP '348 describes a subdivision sequence of said plate by first subdividing the plate into strips, then subdividing each strip into individual pieces. Each subdivision is carried out by raising the plate or strip by means of a pusher having a sharp top edge, which edge is substantially aligned with the fracture line adjacent to element or strip to be separated from the plate. A double ended anvil then descend upon the plate, pressing both sides of the plate on each side of the pusher against said pusher and causing said plate to fracture. The method and device used disadvantageously leave the plate unsupported on both sides of the pusher, increasing the risk of premature separation of plate elements on the feed side of the pusher.

WO2009118959 discloses a method and device for braking glass plate. In this method a glass plate is first provided with fracture lines. The glass plate is positioned on a support surface, the fracture line being positioned above or beyond said support surface. The plate is left with an overhanging portion beyond the fracture line, while at least a portion of the plate before the fracture line is fully supported by the support surface. Fracture of the plate of glass is achieved by applying pressure near the distal end of the overhanging portion of the plate.

DE 10 2012 104903 A1 describes a method for producing metal-ceramic substrates, in particular in the form of printed circuit boards for electric circuits or modules, by applying at least one metallization onto both faces of an insulating layer made of a ceramic material. The insulating layer is separated by introducing a gap. It furthermore shows a method for breaking apart the separate circuits from a larger substrate, but fails to take into account the layers thereon, thus failing to succeed in reliably breaking the separate circuits apart entirely.

Blank T. et al, describes in "Copper thick-film substrate for power electronic applications" (Proceedings of the 5th electronics system-integration technology conference) novel DCB substrate configurations, wherein a paste layer is provided onto a ceramic substrate. It does not mention the issues that occur in singling out the separate circuits, nor does it (unintentionally) provide a solution thereto.

These devices and methods are directed at the subdivision of only brittle materials. Electrical circuits comprise a plurality of material, each material having different hardness. This makes subdivision of circuit boards, in particular those with brittle substrate at least partially covered in a conductive paste layer, both difficult and expensive.

The present invention aims to resolve at least some of the problems and disadvantages mentioned above. The aim of the invention is to provide a method which eliminates those disadvantages. The present invention targets at solving at least one of the aforementioned disadvantages.

### SUMMARY OF THE INVENTION

The present invention and embodiments thereof serve to provide a solution to one or more of above-mentioned disadvantages. To this end, the present invention relates to a method for singling out electronic circuits out of a substrate board comprising a paste layer substantially covering a first side of the substrate board, according to claim 1.

Preferred embodiments of the device are shown in any of the claims 2 to 12. A specific preferred embodiment relates to an invention according to claim 6.

In a second aspect, the present invention relates to a device for singling out electronic circuits out of a substrate board comprising a paste layer substantially covering a first side of the substrate board according to claim 13. Preferred embodiments of the method are shown in any of the claims 14 to 17.

### DESCRIPTION OF FIGURES

The following description of the figures of specific embodiments of the invention is merely exemplary in nature and is not intended to limit the present teachings, their application or uses. Throughout the drawings, corresponding reference numerals indicate like or corresponding parts and features.
**Figure 1** schematically represents the initial stage of the of the removal of a margin using the device according to the invention.
**Figure 2** schematically represents the downwards tilting of the margin using the device according to the invention.
**Figure 3** schematically represents the upwards tilting of the margin using the device according to the invention.
**Figure 4** schematically represents the initial stage of the of the removal of an element being separated from the substrate board using the device according to the invention.
**Figure 5** schematically represents the last stage of the of the removal of an element being separated from the substrate board using the device according to the invention.

### DETAILED DESCRIPTION OF THE INVENTION

The present invention concerns a method for singling out electronic circuits out of a substrate board comprising a paste layer substantially covering a first side of the substrate board, each substrate board comprising a plurality of said circuits disposed in at least one row. The method according to the invention, overcomes the issues related to the division of a board comprising a brittle material and at least one ductile material deposited on the surface of said brittle material. One issue in particular is the separation of the ductile material layer and substrate material. Methods where separation is attained by shearing the substrate board are particularly prone to this type of problem. The method overcomes this and other problems by including a step of controlled fracturing of the brittle material, which leaves any layer of ductile material undamaged. As subsequent step of tilting the board in an opposite direction then advantageously uses the newly formed edge of the brittle material as a fulcrum. Rotation about this fulcrum results in traction being applied to the ductile paste layer, which traction is advantageously directed away from the fracture line and towards the brittle material, thereby creating a completely controlled tear of the past layer along the fracture line. Another significant advantage that other methods do not satisfactorily provide is the reduction of stress to every other part of the board that is not the fracture line being broken. In this way, damage to any other parts of the board is advantageously prevented. This is particularly relevant in situations where the board is already provided with electronic elements, connections or other features that are susceptible to be easily damaged due to mechanical stresses.

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention.

As used herein, the following terms have the following meanings:
"A", "an", and "the" as used herein refers to both singular and plural referents unless the context clearly dictates otherwise. By way of example, "a compartment" refers to one or more than one compartment.

"Comprise", "comprising", and "comprises" and "comprised of" as used herein are synonymous with "include", "including", "includes" or "contain", "containing", "contains" and are inclusive or open-ended terms that specifies the presence of what follows e.g. component and do not exclude or preclude the presence of additional, non-recited components, features, element, members, steps, known in the art or disclosed therein.

Furthermore, the terms first, second, third and the like in the description and in the claims, are used for distinguishing between similar elements and not necessarily for describing a sequential or chronological order, unless specified. It is to be understood that the terms so used are interchangeable under appropriate circumstances and that the embodiments of the invention described herein are capable of operation in other sequences than described or illustrated herein.

The recitation of numerical ranges by endpoints includes all numbers and fractions subsumed within that range, as well as the recited endpoints.

Whereas the terms "one or more" or "at least one", such as one or more or at least one member(s) of a group of members, is clear *per se*, by means of further exemplification, the term encompasses *inter alia* a reference to any one of said members, or to any two or more of said members, such as, e.g., any ≥3, ≥4, ≥5, ≥6 or ≥7 etc. of said members, and up to all said members.

Unless otherwise defined, all terms used in disclosing the invention, including technical and scientific terms, have the meaning as commonly understood by one of ordinary skill in the art to which this invention belongs. By means of further guidance, definitions for the terms used in the description are included to better appreciate the teaching of the present invention. The terms or definitions used herein are provided solely to aid in the understanding of the invention.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to a person skilled in the art from this disclosure, in one or more embodiments. Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In a first aspect, the invention provides a method for singling out electronic circuits out of a substrate board comprising a paste layer substantially covering a first side of the substrate board, each substrate board comprising a plurality of said circuits disposed in at least one row, said substrate board having at least one pair of outer margins on opposite sides of the board, the method comprising the steps of:
singling out at least one strip of electronic circuits out of the substrate board; and
singling out each electronic circuit from at least one strip of electronic circuits; Each step of singling out a strip or an electronic circuit comprises at least one step of fracturing said board or strip along at least one pre-made fracture line, said pre-made fracture line preferably being positioned on a second side of the substrate board opposite to the first side each step of fracturing a board or strip along a fracture line comprises the steps of:
   tilting the strip or the circuit being separated from the board to the first side of the board;
   tilting the strip or the circuit being separated from the board to the second side of the board, past a horizontal position of the strip or the circuit being separated from the board with respect of the board.

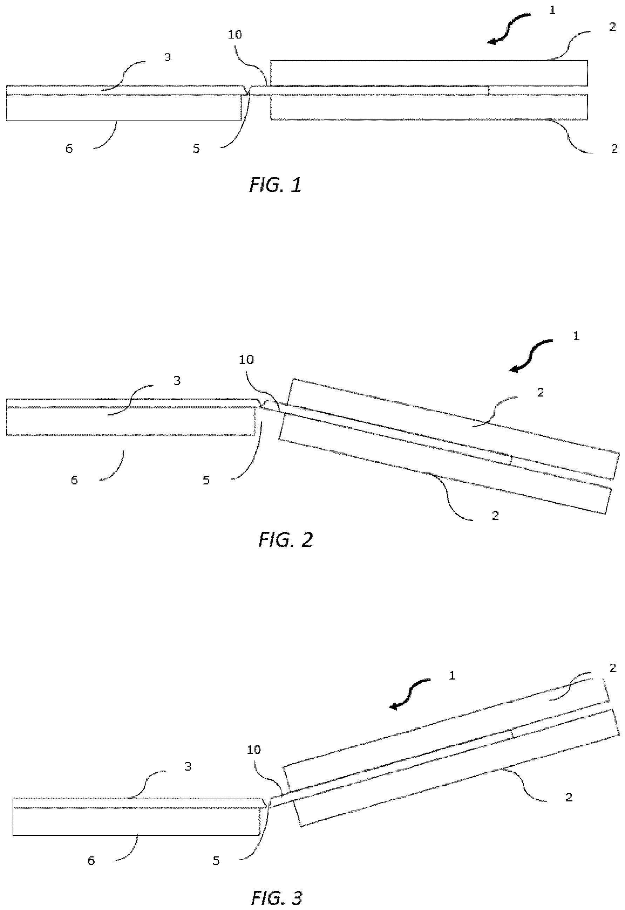

It should be understood that the tilting of the strip/circuit to be separated to the first side of the board, reflects a tilting of said strip/circuit to a position wherein it is substantially entirely at a first side of the board, being tilted over the pre-made fracture line. This is for instance visualized in Figure 2. The tilting towards the second side of the board reflects a tilting of said strip/circuit to a position wherein it is substantially entirely at a second side of the board (opposite to the first side), being tilted again over said fracture line. This is for instance visualized in Figure 3. This second tilting, to the second side of the board means that the strip/circuit to be separated is brought to and then past the original horizontal position, which can be seen in Figure 1 for instance.

The method according to the invention, overcomes the issues related to the division of a board comprising a brittle material and at least one ductile material deposited on the surface of said brittle material. One issue in particular is the separation of the ductile material layer and substrate material. Methods where separation is attained by shearing the substrate board are particularly prone to this type of problem. The method overcomes this and other problems by including a step of controlled fracturing of the brittle material, which leaves any layer of ductile material undamaged. As subsequent step of tilting the board in an opposite direction then advantageously uses the newly formed edge of the brittle material as a fulcrum. Rotation about this fulcrum results in traction being applied to the ductile paste layer, which traction is advantageously directed away from the fracture line and towards the brittle material, thereby creating a completely controlled tear of the past layer along the fracture line. Another significant advantage that other methods do not satisfactorily provide is the reduction of stress to every other part of the board that is not the fracture line being broken. In this way, damage to any other parts of the board is advantageously prevented. This is particularly relevant in situations where the board is already provided with electronic elements, connections or other features that are susceptible to be easily damaged due to mechanical stresses.

In and embodiment, the steps of tilting the element being separated from the board or strip are carried out by means of a plunger equipped with a suction element, a tilting motion being carried out by moving the plunger towards the surface of the strip or board, and the tilting motion in the opposite direction being carried out by establishing suction upon the surface of the board or strip and a return motion of said plunger. Suction elements, being usually made of flexible plastic material are perfectly suited to contact and exert force on delicate elements such as the substrate boards and its sub-constituents without any risk of damage. Due to their flexible properties, the suction elements can be deformed in a plurality of directions which advantageously permits the tilting of said elements without the need for any further mechanical linkages or actuators. This reduces the complexity, and therefore, the cost of the systems applying the present method. By preference, the plunger is also a transportation element capable of moving not only in a substantially vertical direction but also is at least two other directions. In this way, the plunger with the suction elements can separate and transport the separated element without having to regain control or having to pass said separated element to other transport elements, thus, saving on manipulation time and equipment.

In an embodiment, each step of fracturing the board or strip along a fracture line comprises a first step of placing the board or strip on a support element such that the element of the board or strip to be removed overhangs beyond the edge of said support element. Supporting the board in this way advantageously permits an even better control of the forces exerted to the substrate board, further avoiding damage to the board or any other elements deposited onto said board. By preference, the surface supporting the substrate board is raised at least 5 mm, more preferably 6mm, 7mm, 10mm, most preferably a distance equal to the overhanging length of the substrate board for the nearest surface under the any overhanging part of said board. In this way, sufficient clearance is provided such that any spring-back and/or accidental downward motions of the plunger and/or suction device does not result in the separated element of the substrate board or strip impacting against any hard body, possibly causing damage to said separated element.

In an embodiment, during the step of placing the board or strip on a support element the fracture line to be fractured is located between 0mm to 2 mm beyond the edge of the support element. This permits an optimal concentration of the forces applied to the substrate board along the fracture line. By preference, the fracture line is located between 0mm to 1mm beyond the edge of the support element, most preferably between 0mm and 0.5mm.

In an embodiment, after the step of placing the board or strip on a support element, the surface of the board or strip opposite to the support element is retained by at least one movable immobilization element. By preference, the immobilization element comes in contact with the board or strip between the second last fracture line of the board or strip and the last fracture, said last fracture line being the fracture line of the element being separated. Most preferably, the immobilization element comes in contact with the board or strip between the second last fracture line and half the distance to the last fracture line. In this way, it is possible to better control the position of the board or strip as the last fracture line is fractured. The immobilization element may be a ramming element, preferably a plunger with a soft distal end, more preferably a transportation element, most preferably a transportation element equipped with a plunger and a suction element at its distal end. In this way, it is possible to exert force over a larger area of the board or strip, which in combination with the softer distal end of the immobilization element prevents any damage or premature separation of any of the circuits. By having the immobilization element function also as a transportation element, it is possible to reduce the number of handling operations necessary, therefore shortening cycle time.

In an embodiment, method has a step of removing the margins of the board by fracturing the board along fracture lines defined along the edges of the circuits adjacent to the margins, said step of removing the margins preceding the steps of singling out of the strips and circuits. By preference, each margins have a single fracture line along its length and two or less fracture lines substantially perpendicular to said first fracture line. In this way, the substrate boards are advantageously protected from premature fracture along any of the fracture lines of the electronic circuits until all margins are removed. By preference, each side of the substrate board is provided with margins. This makes is impossible to inadvertently and/or prematurely splitting or breaking a substrate board.

In an embodiment, during the step of removing the margins of the board, at least two opposing margins are removed simultaneously. In this way, fewer steps are necessary in order to remove all margins.

In an embodiment, the step of removing the margins includes the steps of:
placing the board on a support element such that at least two opposing margins and their fracture lines overhang beyond each side of the support element;
moving at least two clamping units, each comprising two movable overlapping clamping plates, towards the overhanging margins of the plate, and until each margin is between a pair of clamping plates;
clamping the overhanging margins by closing each pair of clamping plates; tilting each of the closed clamping plates away from the fracture line and about an axis substantially colinear with the fracture lines of each margin;
tilting the each pair of clamping plates towards the fracture line;
   and
opening the clamping plates.

By preference, preceding the step of tilting each of the closed clamping plates away from the fracture line, a limiter element is placed a predetermined distance above the substrate board for limiting excessive bulging during the step of tilting each of the closed clamping plates away from the fracture line, said predetermined distance preferably being less than 10 times, more preferably less than 5 times, even more preferably less than 3 times, the thickness of the board

Preferably, the limiter element is placed after the step of placing the board on a support element. By preference, said board thickness is the thickness of the smallest board which is possible to be processed with a single machine element setup. In this way, it is possible to counter the moments created by the clamping units during tilting of the clamping elements and avoid excessive flexing of the substrate board. This permits avoiding premature separation of any element of the board while enabling the processing of different boards with varying thicknesses without having to change machine setup, which advantageously allows for additional machine flexibility and lower setup costs when processing multiple types of substrate boards. For substrate boards made with more brittle materials, the gap between the limiter element and the board is less than twice, more preferably less that once the thickness of the board.

In an embodiment, after the step of tilting each of the closed clamping plates away from the fracture line the clamping plates of each clamping unit are opened, said clamping plates being closed again after the clamping plates are tilted towards the fracture line. In this way, any tension placed upon the substrate board is advantageously released before the second tilting of the clamping plates. This ensures that paste layer of the substrate boards are never exposed to any tension that promotes the separation of said paste layer from the brittle material of the board.

In an embodiment, after the step of tilting each of the closed clamping plates away from the fracture line, the clamping plates of each clamping unit remain closed and are only opened after said clamping plates are tilted towards the fracture line. This permits a faster separation of the margins from the substrate board.

In an embodiment, characterized in that, the clamping units are retracted after each step of removing the margins. By preference, during the retraction of the clamping units, said clamping units are moved laterally and away from the support element and the substrate board. More preferably the removed margins are held between the clamping plates of the clamping units for at least part of the retraction movement of said units. Most preferably, during said retraction movement, the removed margins impact against at least one ejection element located to at least on, preferably both sides of each clamping unit. In this way, the removed margins travel away from the board and in solidarity with the clamping units before being ejected form said units. Said ejected margins can then be dropped, for example, onto an evacuation chute under each clamping unit, thereby allowing for immediate disposal of said margins and without interrupting or even slowing down the operation.

A second aspect of the invention relates to a device for singling out electronic circuits out of a substrate board comprising a paste layer substantially covering a first side of the substrate board, each substrate board comprising a plurality of said circuits disposed in at least one row, said substrate board having at least one pair of outer margins on opposite sides of the board, the device comprising:
at least one transportation element for transporting and positioning in the device the substrate boards and strips of electronic circuits separated from said boards;
a support element for receiving substrate boards and strips of electronic circuits;
at least one separation unit for splitting substrate boards; and
an immobilization element for retaining each substrate board and strip during separation of the circuit boards;
characterized in that, the distal end of each of the at least one separation unit is capable of tilting in at least two directions.

In an embodiment, the support element has a width that is at least 1 mm smaller that the width of the substrate board without any side margins. This dispenses the need to have multiple support elements in order to perform all the necessary board and strips of electronic element. By preference, the support element comprises a plurality of sub-elements, which sub elements are displaceable in a substantially horizontal plane, either manually, preferably by means of actuators. In this way, the dimensions of the support element are advantageously adjustable, allowing for substate boards of different sizes. The sub-elements of the support element may be movable in discrete elements more preferably is continuous increments. This enables the device to switch between different setups for processing a wide range of different boards.

In an embodiment, the device includes at least two separation units located on opposite sides of the support element, said separation units being clamping units. By preference, each clamping unit is tiltable between -60 degrees and 60 degrees, more preferably -60 degrees and 40 degrees, more preferably -50 degrees and 35 degrees, most preferably -40 degrees and 30 degrees. This permits simultaneous removal of at least two margins of the substrate boards. In an embodiment, the support element may move between stations within the same device, each station having clamping units located on different sides. In a further or another embodiment, one station may be equipped with four clamping units, thereby allowing the removal of al margins in a single station of the device. This permits making the device smaller while maintaining the same functions.

In an embodiment, the device includes at least one separation unit located on the distal end of the device, said separation unit being a transportation element. In this context, the terms distal end of the device may be the side of a workstation that is closest to a following workstation within the same or another device, or it may be understood as a downstream workstation within the same device. By reference, each transportation element comprises a plunger equipped with a suction element, which plunger is movable at least is a substantially vertical direction, and which suction element is capable of tilting in any direction. By preference the suction element is capable of tilting 70 degrees in any direction, more preferably 60 degrees, 55 degrees, 50 degrees, 45 degrees, most preferably 40 degrees. By preference, said suction elements are made of flexible plastic and/or rubber material. This makes them perfectly suited to contact and exert force on delicate elements such as the substrate boards and its sub-constituents without any risk of damage. These materials allow the suction elements to be deformed in a plurality of directions which advantageously permits the tilting of said elements without the need for any further mechanical linkages or actuators. This reduces the complexity, and therefore, the cost of producing, operating and maintaining the device is further reduced. However, it is obvious that the invention is not limited to this application. The method according to the invention can be applied to all sorts of sheet materials comprising at least a first layer of brittle material and a second layer of ductile material. The method is also applicable to only brittle sheet material.

The invention is further described by the following non-limiting examples which further illustrate the invention, and are not intended to, nor should they be interpreted to, limit the scope of the invention.

The present invention will be now described in more details, referring to examples that are not limitative.

### EXAMPLES AND/OR DESCRIPTION OF FIGURES

With as a goal illustrating better the properties of the invention the following presents, as an example and limiting in no way other potential applications, a description of a number of preferred applications of the method and device for singling out electronic circuits out of a substrate board, wherein:
FIG. 1 schematically represents the initial stage of the of the removal of a margin (10) using the device (1) according to the invention. The figure shows the two clamping plates (2) of a clamping unit, said clamping plates (2) being in a substantially horizontal position and exerting clamping force onto the margin (10). The substrate board (3) is shown supported by support element (6) such that the fracture line (5) is positioned overhanging a small distance beyond the edge of said support element (6).
FIG. 2 schematically represents the downwards tilting of the margin (10) using the device (1) according to the invention. A limiting element (not shown) is provided above the substrate board (3) in order to limit flexion and movement of the substrate board (3) during tilting. The figure shows the clamping plates (2) in a first tilted position such that the margin (10) is tilted downwards, imparting a moment about the fracture line (5), causing said fracture line (5) to open and fracture.
FIG. 3 schematically represents the upwards tilting of the margin (10) using the device (1) according to the invention. The figure shows the clamping plates (2) in a second tilted position such that the margin (10) is tilted upwards, causing a paste layer (not shown) on the bottom surface of the substrate board to rupture along the fracture line (5), finalizing the separation of the margin (10) from the substrate board (3). While FIG. 1, FIG. 2 and FIG 3 show the removal of a margin (10) on only one side of the substrate board, a simultaneous removal of a second margin (not shown) opposite to the shown margin (10) is carried out.

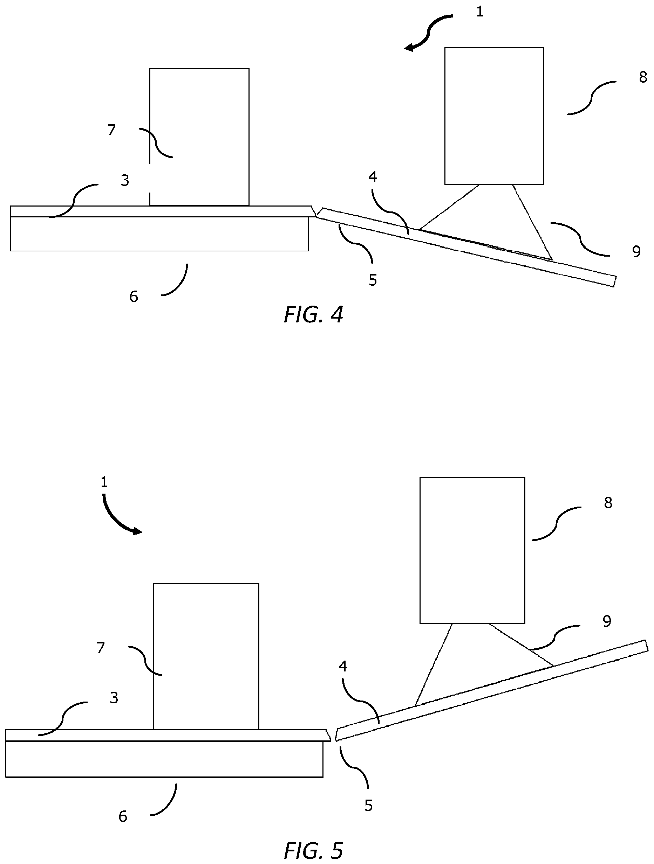

FIG. 4 schematically represents the initial stage of the of the removal of an element being separated (4) from the substrate board (3) using the device (1) according to the invention. The substrate board (3) is shown atop the support elements (6) and immobilized by the immobilization element (7). The figure shows the plunger (8) with the suction element (9) in a lowered position and causing the downwards tilting of the element being separated (4), and thereby, the fracturing of the substrate board (3) along the fracture line (5).
FIG. 5 schematically represents the last stage of the of the removal of an element being separated (4) from the substrate board (3) using the device (1) according to the invention. The substrate board (3) is shown atop the support elements (6) and immobilized by the immobilization element (7). The figure shows the plunger (8) with the suction element (9) in a higher position and causing the upwards tilting of the element being separated (4).

It is supposed that the present invention is not restricted to any form of realization described previously and that some modifications can be added to the presented example of fabrication without reappraisal of the appended claims. For example, the present invention has been described referring to substrate boards, but it is clear that the invention can be applied to all sorts of sheet materials comprising at least a first layer of brittle material and a second layer of ductile material. The method is also applicable to only brittle sheet material.

It is clear that the method according to the invention, and its applications, are not limited to the presented examples.

The present invention is in no way limited to the embodiments described in the examples and/or shown in the figures. On the contrary, methods according to the present invention may be realized in many different ways without departing from the scope of the invention.

### List of numbered items:

- 1: device
- 2: clamping plate
- 3: substrate board
- 4: element being separated
- 5: fracture line
- 6: support element
- 7: immobilization element
- 8: plunger
- 9: suction element
- 10: margin

## Claims

1. Method for singling out electronic circuits out of a substrate board comprising a ductile paste layer substantially covering a first side of the substrate board, each substrate board comprising a plurality of said circuits disposed in at least one row, said substrate board having at least one pair of outer margins on opposite sides of the board, the method comprising the steps of:
singling out at least one strip of electronic circuits out of the substrate board; and
singling out each electronic circuit from at least one strip of electronic circuits;
**characterized in that**, each step of singling out a strip or an electronic circuit comprises at least one step of fracturing said board or strip along at least one pre-made fracture line, said pre-made fracture line being positioned on a second side of the substrate board opposite to the first side each step of fracturing a board or strip along a fracture line comprises the steps of:
tilting the strip or the circuit being separated from the board to the first side of the board;
tilting the strip or the circuit being separated from the board to the second side of the board, past a horizontal position of the strip or the circuit being separated from the board with respect of the board.

2. The method according to claim 1, **characterized in that**, the steps of tilting the element being separated from the board or strip are carried out by means of a plunger equipped with a suction element, a tilting motion being carried out by moving the plunger towards the surface of the strip or board, and the tilting motion in the opposite direction being carried out by establishing suction upon the surface of the board or strip and a return motion of said plunger.

3. The method according to claim 1 or 2, **characterized in that**, each step of fracturing the board or strip along a fracture line comprises a first step of placing the board or strip on a support element such that the element of the board or strip to be removed overhangs beyond the edge of said support element.

4. The method according to any of the previous claims 1-3, **characterized in that**, after the step of placing the board or strip on a support element, the surface of the board or strip opposite to the support element is retained by at least one movable immobilization element.

5. The method according to any of the previous claims, **characterized in that**, method has a step of removing the margins of the board by fracturing the board along fracture lines defined along the edges of the circuits adjacent to the margins, said step of removing the margins preceding the steps of singling out of the strips and circuits.

6. The method according to preceding claim 5, **characterized in that**, during the step of removing the margins of the board, at least two opposing margins are removed simultaneously.

7. The method according to any of the previous claims 5-6, **characterized in that**, the step of removing the margins includes the steps of:
placing the board on a support element such that at least two opposing margins and their fracture lines overhang beyond each side of the support element;
moving at least two clamping units, each comprising two movable overlapping clamping plates, towards the overhanging margins of the plate, and until each margin is between a pair of clamping plates;
clamping the overhanging margins by closing each pair of clamping plates;
tilting each of the closed clamping plates away from the fracture line and about an axis substantially colinear with the fracture lines of each margin;
tilting the each pair of clamping plates towards the fracture line;
and
opening the clamping plates.

8. The method according to claim 7, **characterized in that**, preceding the step of tilting each of the closed clamping plates away from the fracture line, a limiter element is placed a predetermined distance above the substrate board for limiting excessive bulging during the step of tilting each of the closed clamping plates away from the fracture line, said predetermined distance preferably being less than 10 times, more preferably less than 5 times, even more preferably less than 3 times, the thickness of the board.

9. The method according to any of the previous claims 7-8, **characterized in that**, after the step of tilting each of the closed clamping plates away from the fracture line the clamping plates of each clamping unit are opened, said clamping plates being closed again after the clamping plates are tilted towards the fracture line.

10. The method according to any of the previous claims 7-8, **characterized in that**, after the step of tilting each of the closed clamping plates away from the fracture line, the clamping plates of each clamping unit remain closed and are only opened after said clamping plates are tilted towards the fracture line.

11. The method according to any of the previous claims 7-10, **characterized in that**, the clamping units are retracted after each step of removing the margins.

12. A device for singling out electronic circuits out of a substrate board comprising a ductile paste layer substantially covering a first side of the substrate board, each substrate board comprising a plurality of said circuits disposed in at least one row, said substrate board having at least one pair of outer margins on opposite sides of the board, the device comprising:
at least one transportation element for transporting and positioning in the device the substrate boards and strips of electronic circuits separated from said boards;
a support element for receiving substrate boards and strips of electronic circuits;
at least one separation unit for splitting substrate boards; and
an immobilization element for retaining each substrate board and strip during separation of the circuit boards;
**characterized in that**, the distal end of each of the at least one separation unit is capable of tilting in at least two directions.

13. The device according to claim 12, **characterized in that**, the device includes at least two separation units located on opposite sides of the support element, said separation units being clamping units.

14. The device according to any of the previous claims 12-13, **characterized in that**, the device includes at least one separation unit located on the distal end of the device, said separation unit being a transportation element.

15. The device according to any of the previous claims 12-14, **characterized in that**, each transportation element comprises a plunger equipped with a suction element, which plunger is movable at least is a substantially vertical direction, and which suction element is capable of tilting in any direction.
